(19) Europäisches Patentamt / European Patent Office / Office européen des brevets

(11) **EP 1 956 614 B1**

(12) **EUROPÄISCHE PATENTSCHRIFT**

(45) Veröffentlichungstag und Bekanntmachung des Hinweises auf die Patenterteilung:
**01.02.2012 Patentblatt 2012/05**

(51) Int Cl.:
*H01F 6/00* *(2006.01)*     *G01R 33/44* *(2006.01)*

(21) Anmeldenummer: **08002111.6**

(22) Anmeldetag: **05.02.2008**

(54) **Magnetspulensystem mit aktiver Driftkompensation für zwei unabhängige Strompfade**

Magnetic coil system with active drift compensation for two independent current channels

Système de bobines magnétiques doté d'une compensation de dérive pour deux trajets de courant indépendants

(84) Benannte Vertragsstaaten:
**CH DE FR GB LI**

(30) Priorität: **08.02.2007 DE 102007006324**

(43) Veröffentlichungstag der Anmeldung:
**13.08.2008 Patentblatt 2008/33**

(73) Patentinhaber: **Bruker BioSpin AG**
**8117 Fällanden (CH)**

(72) Erfinder:
• **Spreiter, Rolf, Dr.**
**8050 Zürich (CH)**
• **Vonlanthen, Patrik**
**8603 Schwerzenbach (CH)**

(74) Vertreter: **Kohler Schmid Möbus**
**Patentanwälte**
**Ruppmannstraße 27**
**70565 Stuttgart (DE)**

(56) Entgegenhaltungen:
**US-A1- 2006 066 429     US-A1- 2006 103 385**

• **VAN DE KLUNDERT L J M ET AL: "Fully superconducting rectifiers and fluxpumps Part 1: Realized methods for pumping flux" CRYOGENICS, ELSEVIER, KIDLINGTON, GB, Bd. 21, Nr. 4, 1. April 1981 (1981-04-01), Seiten 195-206, XP022804078 ISSN: 0011-2275 [gefunden am 1981-04-01]**

**Beschreibung**

Die Erfindung betrifft ein Magnetspulensystem, das bei einer kryogenen Temperatur zumindest teilweise supraleitend ist, mit mindestens zwei in Serie geschalteten Teilspulen, die jeweils von einem supraleitenden Schalter überbrückt sind, so dass die Teilspulen bei geschlossenen supraleitenden Schaltern unabhängige Stromkreise bilden, wobei zwei Stromkreise einen gemeinsamen Abschnitt aufweisen, und eine Flusspumpe vorgesehen ist.

Ein derartiges Magnetspulensystem ist bekannt aus Van de Klundert L J M et al. "Fully superconducting rectifiers and fluxpumps Part 1: Realized methods for pumping flux" Cryogenics Elsevier, Kidlington, GB, Bd. 21, Nr. 4,1. April 1981, welches als nächstliegender Stand der Technik angesehen wird.

Durch eine Serienschaltung von mehreren supraleitenden Spulen, bei der jede Spule durch einen supraleitenden Schalter überbrückt ist, ist es möglich, die Spulen über eine einzige Stromquelle und ein einziges Paar von Stromzuleitungen sequentiell mit individuellen Strömen zu laden. Sind die Spulen voneinander magnetisch entkoppelt, kann jede Spule mit ihrem Strom direkt geladen werden. Dieses Prinzip wird üblicherweise zum Laden von Shimspulen verwendet, welche so ausgelegt sind, dass sie untereinander nicht koppeln. Ist dies nicht der Fall, müssen die Koppelungen berücksichtigt werden und die Reihenfolge beim Laden muss eingehalten werden.

Dasselbe Prinzip wird auch angewendet um Teilspulen eines Magnetsystems mit unterschiedlichen Strömen zu laden. Dies ist insbesondere interessant, wenn ein Magnetsystem Teilspulen aus konventionellen Supraleitern (=LTS) und aus Hochtemperatur-Supraleiter (=HTS) umfasst. Durch die Benutzung unterschiedlicher Ströme in den verschiedenen Teilspulen erhält man zusätzliche Freiheitsgrade bei der Auslegung des Systems. Da die erhältlichen Dimensionen für HTS eingeschränkt sind, ist man auf diese Freiheitsgrade angewiesen, um ein optimales System auslegen zu können.

In US2006/066429A1 werden zwei Stromkreise verwendet, um einen reinen HTS-und einen reinen LTS-Stromkreis zu erhalten. Dadurch sind keine problematischen supraleitenden Verbindungen zwischen HTS und LTS notwendig und ein driftarmes System könnte so realisiert werden. Die Technologie für supraleitende Verbindungen zwischen gleichartigen Leitern ist vorhanden. Außerdem können durch die Benutzung von zwei Stromkreisen auch die oben erwähnten zusätzlichen Freiheitsgrade in der Auslegung realisiert werden.

Speziell bei der Verwendung von HTS für supraleitende Magnetsysteme, wie sie zum Beispiel für hochauflösende Kernspinresonanz Experimente verwendet werden, ist es jedoch notwendig, einen langsamen Stromverlust (Felddrift) kompensieren zu können. Falls nämlich eine HTS-Spule in Serie zu einer LTS-Spule geschaltet ist, dann sind die Verbindungen zwischen HTS und LTS (HTS-LTS Joints) oft problematisch und führen zu einer Felddrift. Falls die HTS-Spule einen eigenen Strompfad besitzt, ist die Induktivität typischerweise sehr klein. Dies führt schon bei sehr kleinen Problemen mit den Drähten oder den supraleitenden Verbindungen zu einer großen Felddrift, insbesondere da die HTS-Spule einen substantiellen Teil des Feldes beiträgt. HTS haben oft einen kleineren so genannten n-Wert als LTS. Der n-Wert beschreibt den Verlauf des Widerstands R eines Supraleiters in Abhängigkeit von dem den Supraleiter durchfließenden Strom 1, was später noch näher erläutert wird. Der kleinere n-Wert der HTS bedeutet, dass unter Belastung eine höhere Felddrift resultiert, die es zu kompensieren gilt.

Aber auch für LTS-Spulen kann es wünschenswert sein, die Drift kompensieren zu können. Einerseits kann dann die Strombelastung der Drähte erhöht werden, wodurch wiederum kompaktere und kostengünstigere Systeme realisierbar sind, andererseits können im Falle von nicht perfekten supraleitenden Verbindungen oder beschädigten Drähten teure Reparaturen vermieden werden.

Das geeignete Mittel für eine solche Driftkompensation ist eine Flusspumpe. Die Driftkompensation mittels Flusspumpen ist momentan die einzige Möglichkeit, langfristig und kontinuierlich die Drift im "persistent mode" zu kompensieren, d.h. ohne dass der Magnetstrom dauernd in den Kryostaten geleitet werden muss, wie es beim Betrieb eines Magnetspulensystems im "driven mode" der Fall wäre.

Wünschenswert ist es auch, zwei unabhängige Stromkreise zu verwenden, um zusätzliche Freiheitsgrade bei der Auslegung zu erhalten. Dadurch kann man die Supraleiter besser ausnutzen und schlussendlich deshalb auch kompaktere und kostengünstigere System realisieren. Speziell die HTS sind nur in wenigen Dimensionen erhältlich und man braucht die Freiheitsgrade von unterschiedlichen Strömen und unterschiedlichen Spulenabschnitten für eine effektive Auslegung.

Möchte man beides realisieren, zwei unabhängige Stromkreise und Driftkompensation, könnte man jeden Stromkreis mit jeweils einer Flusspumpe ausstatten.

Dies ist aber ein großer Aufwand, benötigt viel Platz im Kryostaten und ist wegen der erhöhten Komplexität auch fehleranfällig. Die Steuerung der Flusspumpen wäre dann auch in doppelter Ausführung notwendig und die Feldregelung komplex. Insbesondere wäre es aufwendig zu bestimmen, welcher Anteil des Feldverlustes von welcher Teilspule herrührt. Dies zu bestimmen wäre jedoch notwendig, um die Leistung der beiden Flusspumpen korrekt zu regulieren und die einzelnen Ströme konstant zu halten. Es ist jedoch wahrscheinlich dass es mit zwei Flusspumpen zu unkontrollierten Umlagerungen von Strom von einem in den anderen Stromkreis kommen würde. Um dies zu verhindern, müsste man wiederum relativ aufwendig die Ströme der Teilspulen messen, zum Beispiel mit Hallsonden inmitten einer Messwicklung etwas außerhalb des Magneten. Es ist jedoch fraglich, ob die benötigte Genauigkeit dieser Messung erreicht werden könnte. Insgesamt erscheint diese Möglichkeit der Driftkompensation nicht praktikabel.

Van de Klundert L J M et al.beschreiben ein Magnetspulensystem, bei dem zwei ungekoppelte Spulen gleichzeitig von einer Quelle gespeist werden können Ausgehend von diesem Stand der Technik ist Aufgabe der Erfindung, ein Magnetspulensystem mit zwei unabhängigen Stromkreisen vorzuschlagen, bei welchem eine vereinfachte Art der Stromregulierung realisiert werden kann.

Diese Aufgabe wird erfindungsgemäß dadurch gelöst, dass die Flusspumpe in den gemeinsamen Abschnitt der Stromkreise zweier Teilspulen geschaltet ist, wobei die Flusspumpe im Betriebszustand von der Summe der Ströme der zwei Teilspulen durchflossen wird.

Bei dem erfindungsgemäßen Magnetspulensystem wird also nur eine einzige Speisung (Flusspumpe) eingesetzt, welche gleichzeitig zwei Stromkreise mit unterschiedlichen Strömen stützen kann. Die Flusspumpe ist so in den supraleitenden Strompfad geschaltet, dass sie von der Summe der Ströme zweier Teilspulen durchflossen wird und auf diese Weise ein allfälliger Spannungsabfall in diesen Teilspulen von der Speisung kompensiert werden kann. Auf diese Weise kann eine Driftkompensation von zwei unabhängigen Stromkreisen erfolgen, ohne dass ein großer apparativer Aufwand betrieben werden muss.

Der Vorteil der Erfindung kommt besonders gut zur Geltung, wenn eine oder mehrere der Teilspulen zumindest teilweise aus Hochtemperatursupraleitermaterial bestehen, da bei HTS-Spulen die Technologie für supraleitende Drahtverbindungen noch problematisch ist und deshalb im Allgemeinen eine höhere Felddrift auftritt.

Das erfindungsgemäße Magnetspulensystem findet vorzugsweise in einem NMR-, MRI-, EPR- oder FTMS-Spektrometer Anwendung.

Die Ströme in den beiden gespeisten Teilspulen stellen sich in einem Verhältnis ein, so dass der Spannungsverlust in beiden Teilspulen gleich ist. Wenn eine konstante Spannung gehalten wird, stellen sich die Ströme also so ein, dass der Supraleiter in beiden Teilspulen gleich belastet wird. Ist in einer Spule zum Beispiel der kritische Strom höher als bei der Auslegung angenommen wurde, so wird dieser Draht dann mehr Strom tragen und der andere etwas entlastet werden. Dem System inhärent ist also ein Selbstregulierungsmechanismus der die Belastung in den zwei Strompfaden gleichmäßig verteilt. Ein gewisser Nachteil dieses Prinzips ist es, dass die genaue Stromverteilung, die resultieren wird, im Voraus nicht genau bekannt ist. Sie hängt ab von den effektiven kritischen Strömen und n-Faktoren der Supraleiter sowie von allfälligen Defekten oder resistiven Drahtverbindungen.

Die im Betriebszustand sich noch langsam ändernde Stromverteilung hat zur Folge dass die Spulenteile der einzelnen Stromkreise für sich eine gewisse Grundhomogenität im erzeugten Feld besitzen müssen, so dass nach den Stromumverteilungen die Gesamthomogenität immer noch genügend gut ist und sich während den Stromumverteilungen die Gesamtgradienten nicht zu schnell ändern. Eine besonders bevorzugte Ausführungsform des erfindungsgemäßen Magnetspulensystems sieht daher vor, dass die zwei Teilspulen im Probenvolumen ein hinreichend homogenes Teilmagnetfeld erzeugen, so dass trotz einer durch die Speisung verursachten Stromumverteilung innerhalb der Teilspulen ein für die Anwendung hinreichend homogenes Magnetfeld im Probenvolumen erzeugt wird, wobei insbesondere der H2 Feldgradient des entsprechenden Teilmagnetfeldes kleiner als 0,1 Gauß/(cm$^2$ A) ist.

Der H2-Gradient ist der Vorfaktor zum Term 2. Grad 0. Ordnung der Entwicklung des Magnetfeldprofils nach Kugelfunktionen in Zylinderkoordinaten und beschreibt den Anteil des Feldprofils längs der Magnetachse z der proportional zu z$^2$ ist.

Muss das Magnetfeld eines Magneten homogenisiert werden, wie das z.B. für NMR, MRI, EPR und FTMS Anwendungen notwendig ist, so muss in erster Linie der H2-Gradient des Magneten minimiert werden. Dies kann zum Beispiel durch kombinieren von Teilspulen mit positiven und negativen H2-Gradienten erreicht werden. Eine Abweichung der Ströme vom Wert für den die Teilspulen ausgelegt wurden, kann dann die Gesamthomogenität so weit verschlechtern, dass das System unbrauchbar wird.

Wenn der H2-Gradient des entsprechenden Teilmagnetfeldes einer Teilspule kleiner als 0,1 Gauß/(cm$^2$ A) ist, wie oben beschrieben, kann der H2-Gradient des Gesamtsystems mit den Raumtemperaturshims korrigiert werden. Bei einer angenommenen typischen Stromdifferenz von 10 A resultiert dann maximal ein H2 Gradient von 1 Gauß/cm$^2$, was in etwa dem halben maximal möglichen Strom in einem typischen Raumtemperaturshimsystem für den Z2 Shim entspricht. Der H2 Gradient einer Teilspule kann zum Beispiel durch die Verwendung einer Notch-Struktur im Wickelpaket reduziert werden. Dazu kann beispielsweise ein Bereich in der Mitte des Wickelpaketes in der Stromdichte reduziert werden, indem in diesem Bereich keine oder weniger Strom führende Windungen vorgesehen sind.

Vorteilhafterweise ist eine oder sind mehrere der Teilspulen weitgehend von den anderen Teilspulen induktiv entkoppelt. Einerseits ist dann das Laden mit der externen Stromquelle einfacher, da die Teilspulen nacheinander mit dem entsprechenden Strom geladen werden können, ohne die Ströme in den anderen Teilspulen stark zu beeinflussen. Andererseits könnten sich bei einem Quench einer Teilspule ohne Entkoppelung gefährlich hohe Ströme in anderen Teilspulen induktiv aufbauen und diese Teilspulen sogar zerstören.

Die Induktivität des Magnetspulensystems, bestehend aus mehreren Teilspulen, kann durch eine symmetrische Induktivitätsmatrix $L_{ij}$ beschrieben werden, wobei die Diagonalelemente der Matrix den Eigeninduktivitäten der Teilspulen entsprechen und die Nichtdiagonalelemente die Koppelung zwischen zwei Teilspulen beschreiben. Die Koppelung zwischen zwei Teilspulen ist klein, wenn das entsprechende Nichtdiagonalelement mindestens einen Faktor 5 kleiner ist als die entsprechenden Diagonalelemente: $L_{kk} \geq 5 \cdot L_{ki} = 5 \cdot L_{ik}$ für alle $i$, mit $i \# k$. Die Teilspulen werden dann als "induktiv entkoppelt" bezeichnet.

Eine spezielle Ausführungsform des erfindungsgemäßen Magnetspulensystems sieht vor, dass eine oder mehrere der Teilspulen in Unterabschnitte unterteilt sind, welche in Serie geschaltet sind.

Bei einer vorteilhaften Weiterbildung dieser Ausführungsform sind die Unterabschnitte zumindest teilweise auf unterschiedlichen Radien angeordnet sind. Das Verteilen von Unterabschnitten einer Teilspule auf verschiedenen Radien kann zur Reduzierung des H2-Gradienten einer Teilspule dienen, wenn die Unterabschnitte so positioniert werden, dass sich die H2 Gradienten der Spulenabschnitte teilweise kompensieren.

Bei einer besonders bevorzugten Ausführungsform sind die Unterabschnitte zumindest teilweise entgegengesetzt polarisiert und wirken dann als aktive Abschirmung des Streufeldes.

Die Erfindung betrifft auch eine Magnetanordnung mit einem erfindungsgemäßen Magnetspulensystem welches in einem Kryostaten mit mindestens einer kryogenen Kammer angeordnet ist, wobei ein gemeinsames Netzgerät für die Teilspulen angeschlossen werden kann, mit dem die Teilspulen über zwei gemeinsame Zuleitungen nacheinander mit unterschiedlichen Strömen geladen werden können.

Bei einer bevorzugten Ausführungsform dieser Magnetanordnung ist die Flusspumpe in der gleichen kryogenen Kammer wie das Magnetspulensystem angeordnet.

Die Erfindung umfasst auch ein Verfahren zum Betrieb eines erfindungsgemäßen Magnetspulensystems, bei dem zum Laden der Teilspulen die Stromkreise mit einem externen Ladegerät verbunden werden und die Betriebsströme der Stromkreise, welche die Flusspumpe enthalten, so gewählt werden, dass diese beiden Stromkreise nach Entfernen des externen Ladegerätes und Einschalten der Flusspumpe ihre Betriebsströme um höchstens 10% ändern bis der stationäre Zustand erreicht ist.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1    einen Schaltplan eines erfindungsgemäßen Magnetspulensystems mit einer Driftkompensation; und

Fig. 2    einen Schaltplan eines Magnetspulensystems gemäß dem Stand der Technik ohne Driftkompensation.

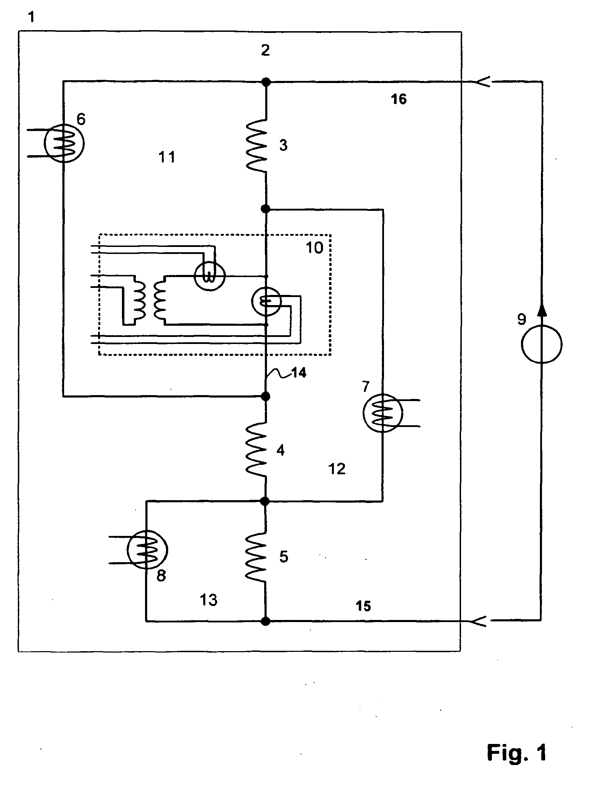

**Fig. 1** zeigt ein erfindungsgemäßes Magnetspulensystem **2,** das in einer kryogenen Kammer **1** angeordnet ist. Das Magnetspulensystem 2 umfasst drei supraleitende Teilspulen **3, 4, 5,** die in Serie geschaltet sind. Jede der Teilspulen 3, 4, 5 ist mit einem supraleitenden Schalter **6, 7, 8** überbrückt. Die Teilspulen 3, 4, 5 bilden so bei geschlossenen supraleitenden Schaltern 6, 7, 8 unabhängige Stromkreise **11, 12, 13.** Das Magnetspulensystem 2 ist zumindest teilweise supraleitend, d.h. es kann resistive Anteile aufweisen, die eine Drift zur Folge haben. Diese resistiven Anteile können beispielsweise auftreten, wenn die supraleitenden Teilspulen nahe an der kritischen Stromstärke betrieben werden. Es ist jedoch auch denkbar, dass in dem Magnetspulensystem 2 verwendete Joints defekt oder resistiv gelötet sind, und somit eine Drift verursachen.

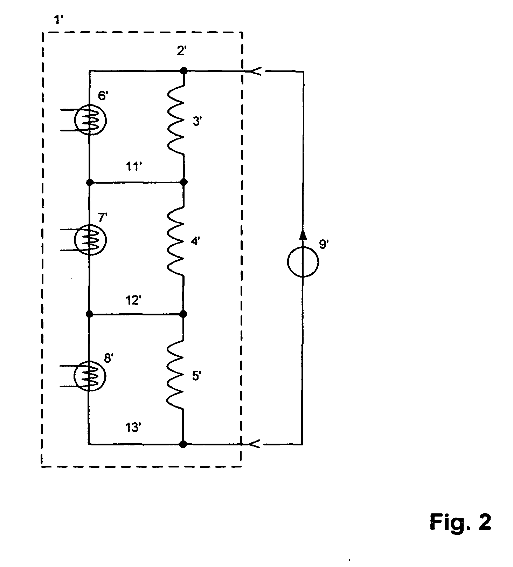

Zum Laden des Magnetspulensystems 2 wird ein Netzgerät **9** über ein Paar von Stromzuleitungen **15, 16** an das Magnetspulensystem 2 angeschlossen. Durch Schließen von einem oder mehreren der supraleitenden Schalter 6, 7, 8 kann der Ladevorgang der von den jeweiligen geschlossenen Schaltern überbrückten Teilspulen unterbrochen werden, während der Ladevorgang der Teilspulen, deren Schalter nicht geschlossen sind, weitergeführt werden kann. Auf diese Weise können die Teilspulen 3, 4, 5 auf verschiedene Betriebsströme aufgeladen werden. Dies ist auch mit dem aus dem Stand der Technik bekannten Magnetspulensystem 2' möglich, welches in **Fig. 2** dargestellt ist.

Im Gegensatz zu dem bekannten, in Fig. 2 gezeigten Magnetspulensystem 2' sind die Teilspulen 3, 4, 5 bei dem erfindungsgemäßen Magnetspulensystem 2 so überbrückt, dass die Stromkreise 11, 12 der Teilspulen 3, 4 einen gemeinsamen Abschnitt **14** aufweisen. Bei den Teilspulen 3, 4, 5 kann es sich um HTS- oder LTS-Spulen handeln. Vorzugsweise wird eine der beiden Teilspulen 3, 4, deren Stromkreise 11, 12 den gemeinsamen Abschnitt 14 aufweisen, aus HTS-Material gefertigt sein, während die andere Teilspule eine LTS-Spule ist.

In dem gemeinsamen Abschnitt 14 ist eine Flusspumpe **10** vorgesehen, welche sowohl die Teilspule 3 als auch die Teilspule 4 speist. Auf diese Weise können mit nur einer einzigen Flusspumpe 10 zwei Teilspulen gespeist und somit auf effektive Weise die im Magnetspulensystem auftretende Drift von zwei Teilspulen, welche mit unterschiedlichen Strömen betrieben werden können, gleichzeitig kompensiert werden. In Fig. 1 ist eine spezielle Bauart einer Flusspumpe 10 gezeigt, es sind aber auch andere Ausführungsformen von Flusspumpen einsetzbar.

Mit dem erfindungsgemäßen Magnetspulensystem können somit auch nicht perfekte HTS-LTS, LTS-LTS oder HTS-HTS Joints eingesetzt werden, ohne dass dadurch durch eine starke Drift das Magnetsystem unbrauchbar wird.

Zur Feldstabilisierung des Gesamtsystems wird einzig die Spannung der Speisung geregelt. Bei einer typischen Flusspumpe ist diese Spannung sehr klein und bewegt sich im Bereich 0 .. 0.1 mV. Typischerweise wird eine der Teilspulen 3, 4 eine viel kleinere Induktivität haben als die andere Teilspule, da z.B. eine Teilspule mit HTS nur für den innersten Teil des Magnetspulensystems 2 verwendet wird und demzufolge ein kleine Induktivität besitzen wird. Regelt man ein solches System aus großer und kleiner Induktivität über eine gemeinsame Spannung, so wird immer zuerst die Teilspule mit der kleinen Induktivität reagieren um das Sollfeld zu halten und danach finden mit großer Zeitkonstante Stromumverteilungen statt bis der Gleichgewichtszustand erreicht ist. Eine Spule mit kleiner Induktivität zu haben ist von Vorteil, da dadurch das System schneller reagiert als wenn die Flusspumpe über dem ganzen Magneten betrieben wird. Somit kann das Feld besser geregelt werden.

Beim Laden der Teilspulen 3, 4 werden die Ströme in den Teilspulen 3, 4 so angepasst, dass die beiden Stromkreise 11,12, in denen sich die Teilspulen 3, 4 befinden, die gleiche Spannung zur Aufrechterhaltung konstanter Ströme benötigen. Zwar besitzt das System einen Selbstregulierungsmechanismus, wobei sich die Ströme in den unabhängigen Stromkreisen prinzipiell selbst so einstellen, dass der Spannungsverlust in beiden Teilspulen gleich ist, jedoch spielt sich diese Stromumverteilung auf einer Zeitskala von Monaten oder Jahren ab, so dass beim Laden eine erste, grobe Einstellung der benötigten Ströme notwendig ist, wie im Folgenden beschrieben:

Ein realer Supraleiter besitzt einen Restwiderstand, der umso größer wird, je näher man sich dem kritischen Strom $I_c$ nähert. Der Spannungsabfall pro Meter Leiterlänge kann mit folgender Gleichung angenähert werden:

$$U = 10 \frac{\mu V}{m} \cdot L \cdot \left( \frac{I}{I_c} \right)^n$$

wobei der kritische Strom $I_c$ so definiert ist, dass bei einem Strom $I = I_c$ pro Meter Leiterlänge eine Spannung von 10 $\mu V$ abfällt. L ist die Länge des Leiters und der Exponent n wird n-Faktor genannt und hat für übliche Supraleitermaterialien einen Wert in der Größenordnung von 20 bis 40. Da der kritische Strom $I_c$ und der n-Faktor Funktionen der magnetischen Feldstärke sind und diese Feldstärke vom Ort in der Spule abhängt, muss über die Leiterlänge integriert werden. Für den totalen Spannungsabfall einer Spule erhält man dann:

$$U_t = 10 \frac{\mu V}{m} \int_0^L \left( \frac{I}{I_c(x)} \right)^{n(x)} dx$$

Will man mit zwei Teilspulen ein gewisses Sollfeld $B_{tot}$ erreichen, wobei in beiden Teilspulen der gleiche Spannungsabfall auftreten soll, so müssen die folgenden zwei Gleichungen erfüllt sein:

$$\int_0^{L_1} \left( \frac{I_1}{I_{c1}(x)} \right)^{n1(x)} dx = \int_0^{L_2} \left( \frac{I_2}{I_{c2}(x)} \right)^{n2(x)} dx,$$
$$A_1 I_1 + A_2 I_2 = B_{tot},$$

und

wobei $A_1$ und $A_2$ die generierten Feldstärken im Probenvolumen pro Ampere Strom der jeweiligen Teilspule sind. Aus den obigen 2 Gleichungen lassen sich dann numerisch die benötigten Betriebsströme $I_1$ und $I_2$ der Teilspulen bestimmen. Das Ermitteln der Ströme auf diese Art und Weise wird natürlich nie ganz exakt sein, da die Materialeigenschaften des Supraleiters auch nicht exakt bekannt sind.

Die Abweichung der Ströme vom idealen Wert der obigen Formeln hat Abweichungen in der Homogenität zur Folge, da die Teilspulen für sich alleine typischerweise eine schlechtere Homogenität haben als das gesamte Magnetspulensystem, speziell der H2 Gradient. Das System muss so dimensioniert sein, dass diese Abweichung entweder toleriert werden kann, oder von einem Raumtemperaturshimsystem, wie es typischerweise für NMR Spektrometer zur Anwendung kommt, korrigiert werden kann. Wenn eines dieser Kriterien erfüllt ist, wird das Magnetfeld im Probenvolumen als hinreichend homogen angesehen. Die Abweichung von der idealen Stromverteilung darf den H2 Gradienten um maximal 1 Gauß / cm$^2$ verändern damit das obige Kriterium erfüllt ist. Es ist sinnvoll die Teilspulen so auszulegen, dass der Feldgradient der Teilspulen kleiner als 0.1 Gauß / (cm$^2$A) ist. Dann kann eine Stromabweichung nach dem Laden von 10 A toleriert werden, da der dadurch verursachte H2 Gradient etwa mit dem halben Maximalstrom eines typischen Raumtemperaturshimsystems kompensiert werden kann, so dass man in der Praxis sicher keine Probleme hat einen genügend genauen Anfangsladezustand zu erreichen. Eine Bedingung hierfür ist, dass die Materialparameter der Supraleiter relativ gut bekannt sind, was mit den heutigen Messmethoden jedoch kein Problem darstellt.

An einem Modellbeispiel wird das Verhalten der erfindungsgemäßen Anordnung erläutert. Die Simulation wurde mit der Software Simplorer Version 7.0 durchgeführt. Das Modellsystem besteht aus den zwei Teilspulen 3 und 4 mit unterschiedlichen Betriebsströmen und der gemeinsamen Flusspumpe 10. Die Teilspule 3 ist aus HTS gefertigt, während dem die Teilspule 4 aus konventionellem Supraleiter (LTS) gewickelt ist. Folgende Parameter wurden für die Teilspulen verwendet.

|  | Teilspule 3 (HTS) | Teilspule 4 (LTS) |
|---|---|---|
| Induktivität | 1 H | 140 H |
| Betriebsstrom | 119.836 A | 244.968 A |
| Index n | 20 | 40 |
| Ic | 170 A | 350 A |
| Widerstand $R_s$ bei Ic | 0.1 mΩ | 2 mΩ |
| Generiertes Feld pro A | 0.9 MHz / A | 2.418 MHz / A |

Zur Vereinfachung der Simulation wurde eine integrierte Form der Strom - Spannungsrelation verwendet. Dies ist natürlich nur eine Näherung, beschreibt aber qualitativ das Verhalten der Spulen.

$$ U = R_s \cdot \left( \frac{I}{I_c} \right)^n . $$

Die beiden Spulen werden als voneinander entkoppelt angenommen und die

Flusspumpe generiere eine konstante Stützspannung von 11 μV. Die Parameter wurden so gewählt, dass das System stationär bleibt, das heißt, der Spannungsverlust durch den endlichen n-Wert wird für beide Teilspulen durch die von der Flusspumpe generierte Spannung kompensiert. Das resultierende Gesamtfeld entspricht dann 700.186 MHz NMR Protonenfrequenz.

Wir nehmen jetzt an, dass der Supraleiter der HTS-Spule einen kritischen Strom Ic hat, der 10 A über dem für die Berechnung verwendeten Wert liegt, also Ic = 180 A. Die HTS-Spule lädt sich dann innerhalb von 13 Tagen auf 126.55 A auf und das resultierende Feld steigt auf 706.225 MHz. Die Stützspannung muss deswegen auf 4 μV reduziert werden, damit die LTS-Spule stationär bleibt und das Sollfeld in diesem Fall gehalten wird. Als nächstes folgt ein Ausgleichsprozess zwischen den beiden Teilspulen, der sehr langsam ist und sich über Jahre hinzieht. Die LTS-Spule entlädt sich sehr langsam und die Stützspannung muss sukzessive wieder auf 8.5 μV erhöht werden, bis ein neuer stationärer Zustand erreicht ist. Die Ströme sind dann neu verteilt und betragen neu 125.0 A für den HTS und 242.97 A für den LTS. Die HTS-Spule, deren Leiter besser als erwartet ist, muss ca. 5.2 A zusätzlichen Strom tragen, dafür wird die LTS-Spule in diesem Fall um 2 A entlastet.

Das Beispiel zeigt, dass Abweichungen der Materialparameter von den für die Auslegung verwendeten Werten eine Stromumverteilung zwischen den Teilspulen bewirken. Diese Stromumverteilungen sind sehr träge und werden vom Anwender des Systems gar nicht bemerkt.

**Bezugszeichenliste**

1, 1'       kryogene Kammer
2, 2'       Magnetspulensystem
3, 3'       Teilspule
4, 4'       Teilspule
5, 5'       Teilspule
6, 6'       supraleitender Schalter
7, 7'       supraleitender Schalter

| 8, 8' | supraleitender Schalter |
|---|---|
| 9, 9' | Netzgerät |
| 10 | Flusspumpe |
| 11, 11' | Stromkreis |
| 12, 12' | Stromkreis |
| 13, 13' | Stromkreis |
| 14 | gemeinsamer Abschnitt der Stromkreise 11 und 12 |

**Patentansprüche**

1. Magnetspulensystem (2), das bei einer kryogenen Temperatur zumindest teilweise supraleitend ist, mit mindestens zwei in Serie geschalteten Teilspulen (3, 4, 5), die jeweils von einem supraleitenden Schalter (6, 7, 8) überbrückt sind, so dass die Teilspulen bei geschlossenen supraleitenden Schaltern (6, 7, 8) unabhängige Stromkreise (11, 12, 13) bilden, wobei zwei Stromkreise (11, 12) einen gemeinsamen Abschnitt aufweisen, und eine Flusspumpe (10) vorgesehen ist,
**dadurch gekennzeichnet, dass**
die Flusspumpe (10) in den gemeinsamen Abschnitt (14) der Stromkreise (11, 12) zweier Teilespulen (3, 4) geschaltet ist, wobei die Flusspumpe (10) im Betriebszustand von der Summe der Ströme der zwei Teilspulen (3, 4) durchflossen wird.

2. Magnetspulensystem (2) nach einem der vorherigen Ansprüche, **dadurch gekennzeichnet, dass** eine oder mehrere der Teilspulen (3, 4, 5) zumindest teilweise aus Hochtemperatursupraleitermaterial bestehen.

3. Magnetspulensystem (2) nach einem der vorherigen Ansprüche, **dadurch gekennzeichnet, dass** das Magnetspulensystem (2) in einem NMR-, MRI-, EPR- oder FTMS- Spektrometer Anwendung findet.

4. Magnetspulensystem (2) nach Anspruch 3, **dadurch gekennzeichnet, dass** die zwei Teilspulen (3, 4) im Probenvolumen ein hinreichend homogenes Teilmagnetfeld erzeugen, so dass trotz einer durch die Speisung (10) verursachten Stromumverteilung innerhalb der Teilspulen ein für die Anwendung hinreichend homogenes Magnetfeld im Probenvolumen erzeugt wird, wobei insbesondere der H2 Feldgradient des entsprechenden Teilmagnetfeldes kleiner als 0,1 Gauß/(cm$^2$ A) ist.

5. Magnetspulensystem (2) nach einem der vorherigen Ansprüche, **dadurch gekennzeichnet, dass** eine oder mehrere der Teilspulen (3, 4, 5) weitgehend von den anderen Teilspulen induktiv entkoppelt ist.

6. Magnetspulensystem (2) nach einem der vorherigen Ansprüche, **dadurch gekennzeichnet, dass** eine oder mehrere der Teilspulen (3, 4, 5) in Unterabschnitte unterteilt sind, welche in Serie geschaltet sind.

7. Magnetspulensystem (2) nach Anspruch 6, **dadurch gekennzeichnet, dass** Unterabschnitte zumindest teilweise auf unterschiedlichen Radien angeordnet sind.

8. Magnetspulensystem (2) nach Anspruch 6 oder 7, **dadurch gekennzeichnet, dass** die Unterabschnitte zumindest teilweise entgegengesetzt polarisiert sind und diese dann als aktive Abschirmung des Streufeldes wirken.

9. Magnetanordnung mit einem Magnetspulensystem (2) nach einem der vorhergehenden Ansprüche, welches in einem Kryostaten mit mindestens einer kryogenen Kammer angeordnet ist, wobei ein gemeinsames Netzgerät (9) für die Teilspulen (3, 4, 5) angeschlossen werden kann, mit dem die Teilspulen (3, 4, 5) über zwei gemeinsame Zuleitungen nacheinander mit unterschiedlichen Strömen geladen werden können.

10. Magnetanordnung nach Anspruch 9, **dadurch gekennzeichnet, dass** die Flusspumpe (10) in der gleichen kryogenen Kammer (1) wie das Magnetspulensystem (2) angeordnet ist.

11. Verfahren zum Betrieb eines Magnetspulensystems nach einem der Ansprüche 1 bis 8, **dadurch gekennzeichnet, dass** zum Laden der Teilspulen (3, 4, 5) die Stromkreise (11, 12, 13) mit einem externen Ladegerät (9) verbunden werden und die Betriebsströme der Stromkreise (11, 12), welche die Flusspumpe enthalten, so gewählt werden, dass diese beiden Stromkreise (11, 12) nach entfernen des externen Ladegerätes (9) und einschalten der Flusspumpe (10) ihre Betriebsströme um höchstens 10% ändern bis der stationäre Zustand erreicht ist.

**Claims**

1. Magnet coil system (2) which is at least partially superconducting at a cryogenic temperature, comprising at least two partial coils (3, 4, 5) which are connected in series and are each bridged by a superconducting switch (6, 7, 8), such that the partial coils form independent electric loops (11, 12, 13) when the superconducting switches (6, 7, 8) are closed, wherein two electric loops (11, 12) have a common section and a flux pump (10) is provided, **characterized in that** the flux pump (10) is circuited in the common section (14) of the electric loops (11, 12) of two partial coils (3, 4), wherein the total sum of the currents of the two partial coils (3, 4) flows through the flux pump (10) in the operating state.

2. Magnet coil system (2) according to any one of the preceding claims, **characterized in that** one or more of the partial coils (3, 4, 5) at least partially consist of high-temperature superconducting material.

3. Magnet coil system (2) according to any one of the preceding claims, **characterized in that** the magnet coil system (2) is used in an NMR, MRI, EPR or FTMS spectrometer.

4. Magnet coil system (2) according to claim 3, **characterized in that** the two partial coils (3, 4) generate a sufficiently homogeneous partial magnetic field in the sample volume, such that despite the current redistribution within the partial coils caused by the supply (10), a magnetic field is generated in the sample volume, which is sufficiently homogeneous for the application, wherein, in particular, the H2 field gradient of the corresponding partial magnetic field is smaller than 0.1 Gauss/(cm$^2$A).

5. Magnet coil system (2) according to any one of the preceding claims, **characterized in that** one or more of the partial coils (3, 4, 5) are largely inductively decoupled from the other partial coils.

6. Magnet coil system (2) according to any one of the preceding claims, **characterized in that** one or more of the partial coils (3, 4, 5) are divided into subsections which are connected in series.

7. Magnet coil system (2) according to claim 6, **characterized in that** the subsections are at least partially arranged on different radii.

8. Magnet coil system (2) according to claim 6 or 7, **characterized in that** the subsections are at least partially oppositely polarized, and then act as active shielding of the stray field.

9. Magnet configuration comprising a magnet coil system (2) according to any one of the preceding claims, which is disposed in a cryostat with at least one cryogenic chamber, wherein a common power supply (9) for the partial coils (3, 4, 5) can be connected, with which the partial coils (3, 4, 5) can be successively loaded with different currents via two common supply lines.

10. Magnet configuration according to claim 9, **characterized in that** the flux pump (10) is disposed in the same cryogenic chamber (1) as the magnet coil system (2).

11. Method of operating a magnet coil system according to any one of the claims 1 through 8, **characterized in that** the electric loops (11, 12, 13) are connected to an external charging device (9) for charging the partial coils (3, 4, 5), and the operating currents of the electric loops (11, 12) which contain the flux pump are selected such that the operating currents of these two electric loops (11, 12) change by maximally 10% after removing the external charging device (9) and switching on the flux pump (10) until the stationary state is reached.

**Revendications**

1. Système de bobines magnétiques (2) qui est au moins partiellement supraconducteur à une température cryogénique et qui comporte au moins deux bobines partielles (3, 4, 5) branchées en série qui sont court-circuitées chacune par un commutateur supraconducteur (6, 7, 8) de sorte que les bobines partielles forment des circuits (11, 12, 13) indépendants quand les commutateurs supraconducteurs (6, 7, 8) sont fermés, deux circuits (11, 12) présentant une section commune et une pompe de flux (10) étant prévue,
**caractérisé en ce**
**que** la pompe de flux (10) est branchée dans la section commune (14) des circuits (11, 12) de deux bobines partielles (3, 4), la pompe de flux (10) étant traversée, dans l'état de fonctionnement, par la somme des courants des deux bobines partielles (3, 4).

2. Système de bobines magnétiques (2) selon une des revendications précédentes, **caractérisé en ce qu'**une ou plusieurs des bobines partielles (3, 4, 5) sont composées au moins partiellement de matériau supraconducteur à haute température.

3. Système de bobines magnétiques (2) selon une des revendications précédentes, **caractérisé en ce que** le système de bobines magnétiques (2) est utilisé dans un spectromètre RMN, IRM, EPR ou FTMS.

4. Système de bobines magnétiques (2) selon la revendication 3, **caractérisé en ce que** les deux bobines partielles (3, 4) génèrent dans le volume d'échantillon un champ magnétique partiel suffisamment homogène pour que, malgré une redistribution de courant à l'intérieur des bobines partielles provoquée par l'alimentation (10), un champ magnétique suffisamment homogène pour l'application soit généré dans le volume d'échantillon, le gradient de champ H2 du champ magnétique partiel correspondant étant en particulier inférieur à 0,1 gauss/(cm$^2$ A).

5. Système de bobines magnétiques (2) selon une des revendications précédentes, **caractérisé en ce qu'**une ou plusieurs des bobines partielles (3, 4, 5) est/sont en grande partie découplée(s) inductivement des autres bobines partielles.

6. Système de bobines magnétiques (2) selon une des revendications précédentes, **caractérisé en ce qu'**une ou plusieurs des bobines partielles (3, 4, 5) est/sont divisée(s) en sous-sections qui sont branchées en série.

7. Système de bobines magnétiques (2) selon la revendication 6, **caractérisé en ce que** les sous-sections sont disposées au moins partiellement sur différents rayons.

8. Système de bobines magnétiques (2) selon la revendication 6 ou 7, **caractérisé en ce que** les sous-sections sont, au moins partiellement, polarisées en sens contraire et font alors fonction de blindage actif du champ de dispersion.

9. Dispositif magnétique avec un système de bobines magnétiques (2) selon une des revendications précédentes, lequel est disposé dans un cryostat avec au moins une chambre cryogénique, un appareil d'alimentation (9) commun aux bobines partielles (3, 4, 5) pouvant être raccordé, au moyen duquel les bobines partielles (3, 4, 5) peuvent être chargées successivement par des courants différents via deux lignes d'alimentation communes.

10. Dispositif magnétique selon la revendication 9, **caractérisé en ce que** la pompe de flux (10) est disposée dans la même chambre cryogénique (1) que le système de bobines magnétiques (2).

11. Procédé de fonctionnement d'un système de bobines magnétiques selon une des revendications 1 à 8, **caractérisé en ce que** pour charger les bobines partielles (3, 4, 5), les circuits (11, 12, 13) sont reliés à un chargeur externe (9) et les courants de fonctionnement des circuits (11, 12) qui contiennent la pompe de flux sont choisis de façon que les courants de fonctionnement de ces deux circuits (11, 12) varient de 10 % au maximum avant que l'état stationnaire soit atteint après que le chargeur externe (9) a été retiré et la pompe de flux (10) mise en route.

**Fig. 1**

**Fig. 2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006066429 A1


**In der Beschreibung aufgeführte Nicht-Patentliteratur**

- **Van de Klundert L J M et al.** Fully superconducting rectifiers and fluxpumps Part 1: Realized methods for pumping flux. *Cryogenics Elsevier,* 01. April 1981, vol. 21 (4